Europäisches Patentamt

European Patent Office

Office européen des brevets

(19)

(11) Publication number: **0 146 212**
A1

## (12) EUROPEAN PATENT APPLICATION

(21) Application number: **84306239.9**

(22) Date of filing: **12.09.84**

(51) Int. Cl.⁴: **H 01 L 21/285,** H 01 L 29/91, H 01 L 29/40

(30) Priority: **14.09.83 US 531962**

(43) Date of publication of application: **26.06.85 Bulletin 85/26**

(84) Designated Contracting States: **DE FR GB IT NL**

(71) Applicant: **TEKTRONIX, INC., Tektronix Industrial Park D/S Y3-121 4900 S.W. Griffith Drive P.O. Box 500, Beaverton Oregon 97077 (US)**

(72) Inventor: **Ulrich, Ralph P., Star Route, Big Arm Montana 59910 (US)**

(74) Representative: **Baillie, Iain Cameron et al, c/o Ladas & Parry Isartorplatz 5, D-8000 München 2 (DE)**

(54) Schottky barrier diode and method of manufacturing it.

(57) A semiconductor device is manufactured by providing a layer of barrier metal on a restricted surface region of a body of semiconductor material while leaving other regions of the surface exposed, providing a layer of insulating material over the exposed regions of the body of semiconductor material and over a peripheral region of the layer of barrier metal while leaving a central region of the layer of barrier metal exposed through an aperture in the layer of insulating material, and establishing ohmic connection to the central region of the layer of barrier metal by way of the aperture in the layer of insulating material. Preferably, the restricted surface region of the body of semiconductor material is the top surface of a mesa formed by selective etching of the semiconductor material using the barrier metal as a mask.

SEMICONDUCTOR DEVICE, AND METHOD
OF MANUFACTURING A SEMICONDUCTOR DEVICE

This invention relates a semiconductor device, and a method of manufacturing a semiconductor device.

## Background of the Invention

It is known to manufacture a Schottky barrier diode by depositing a layer of a noble, refractory metal such as Pt on a surface of a silicon substrate. A layer of intermediate barrier metal, such as, Ti, W or a mixture of Ti and W (TiW), is deposited on top of the barrier metal, and a layer of anode metal such as Al, is deposited on top of the intermediate barrier metal. A problem exists with the conventional Schottky barrier diode, in that its reverse bias characteristics are easily degraded by reverse-current stresses.

## Summary of the Invention

According to a first aspect of the present there is provided a method of manufacturing a semiconductor device comprising the steps of (a) providing a layer of barrier metal on a restricted surface region of a body of semiconductor material, while leaving other regions of the surface, surrounding said restricted surface region, exposed, (b) providing a layer of insulating material over said other regions of the body of semiconductor material and over a peripheral region of the layer of barrier metal while leaving a central region of the layer of barrier metal exposed through an aperture in the layer of insulating material, and (c) establishing ohmic connection to the central region of the layer of barrier metal by way of said aperture in the layer of insulating material.

According to a second aspect of the present invention there is provided a semiconductor device comprising a body of semiconductor material having a major surface, a layer of barrier metal on a restricted surface region of the major surface on the body of semiconductor material, a layer of insulating material covering regions of the major surface of the body of semiconductor material other than said restricted region and also covering the perimeter of the layer of barrier metal, and means for establishing ohmic connection to a central region of the layer of barrier metal.

According to a third aspect of the present invention there is provided a method of manufacturing a semiconductor device, comprising the steps of: (a) providing a body of semiconductor material having a region of one conductivity type, said region being bounded by a substantially planar surface of the body and extending to a substantially uniform first predetermined depth beneath said surface; (b) providing a layer of barrier metal on said surface of the body; (c) removing the barrier metal from selected regions of said surface and removing semiconductor material from said selected regions to a second predetermined depth, greater than said first predetermined depth so as to provide a mesa having a layer of barrier metal on its top surface; and (d) establishing ohmic contact to the layer of barrier metal on the top surface of the mesa.

According to a fourth aspect of the present invention there is provided a semiconductor device comprising a body of semiconductor material having a mesa extending from one surface thereof, the mesa having a top surface and including a region of semiconductor material of one type bounded by said top surface and a generally planar surface at a depth below said top surface which is less than the height of the mesa, and the device also comprising a layer of barrier metal on

-3-

said top surface of the mesa, and means for establishing ohmic contact to said layer of barrier metal.

## Brief Description of the Drawings

For a better understanding of the invention, and to show how the same may be carried into effect, reference will now be made, by way of example, to the accompanying drawing, in which,

FIG. 1 is a sectional view of a conventional Schottky barrier diode; and

FIG. 2 is a sectional view of a Schottky barrier diode embodying the present invention.

In the different figures, like reference numerals denote corresponding elements.

## Detailed Description

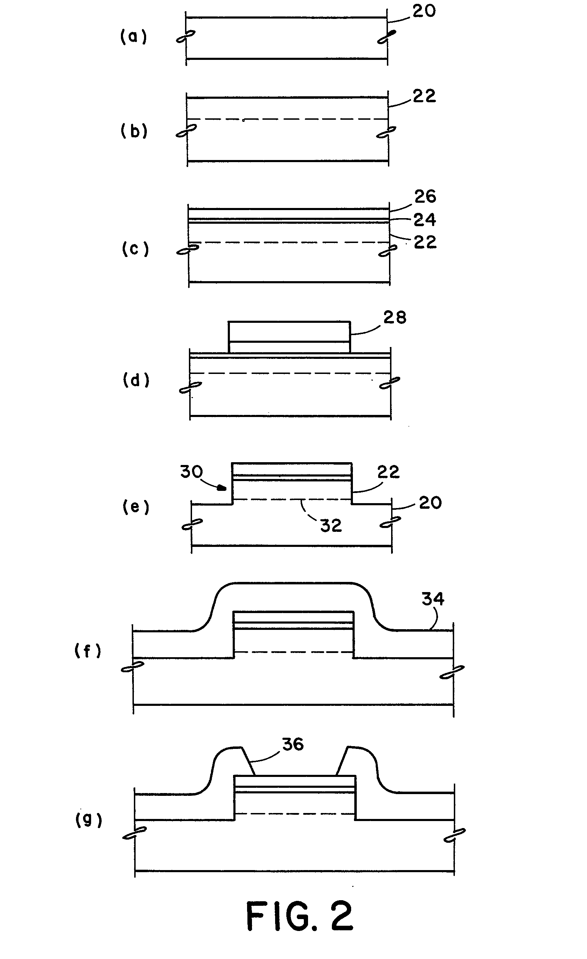

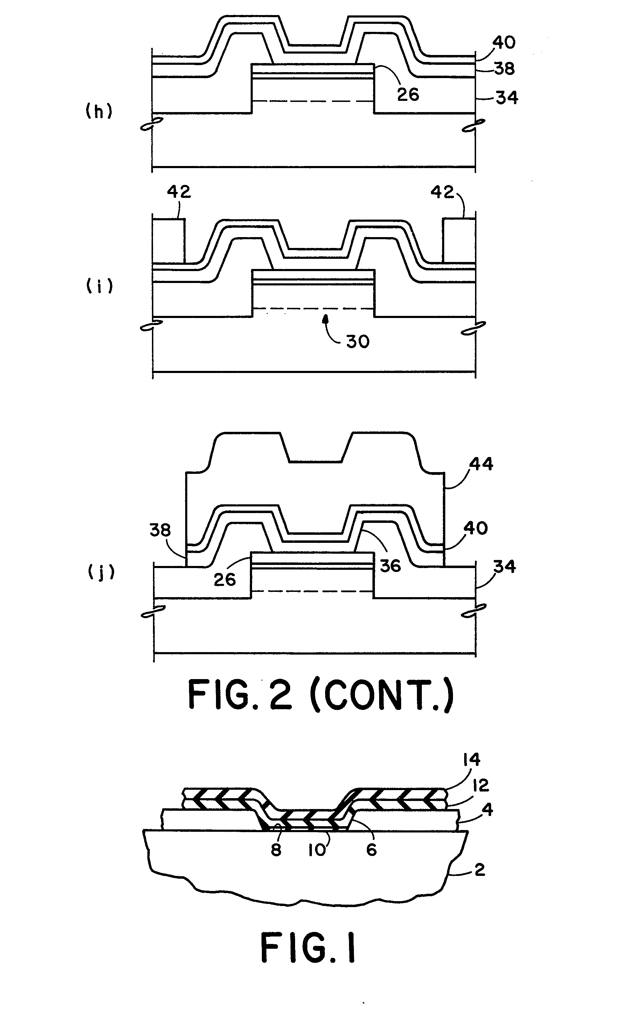

The conventional Schottky barrier diode shown in FIG. 1 is fabricated on a silicon wafer 2 by depositing thereon a layer of silicon dioxide 4, selectively etching the silicon dioxide to form a via 6 and through which a portion 8 of the surface of the wafer is exposed, and then depositing on the surface portion 8 a layer 10 of Schottky barrier metal, such as Pt. A layer 12 of intermediate barrier metal, such as TiW, is deposited on the wafer so that it covers the layer 10, the walls of the via 6 and a portion of the surface of the layer 4 surrounding the via 6. A layer 14 of anode metal, e.g. Al, is formed on top of the layer 12.

It is well known that the most active region of the Schottky barrier diode shown in FIG. 1 is at the perimeter of the device, and that the characteristics of the diode are sensitive to the perimeter to area ratio of the device. The reverse characteristics of the device are easily degraded by reverse-current stresses. This degradation occurs at the device perimeter. Two possible reasons have been advanced for this degradation, one being that the degradation is caused by physcial stress concentrations at the device perimeter due to the proximity of the oxide layer, and the other being that the degradation is caused by sharp-edge effects around the diode perimeter and an MIS diode in parallel with the normal Schottky barrier diode. It is believed that these physical stresses affect the reverse-bias current/voltage characteristic of the device. Finally, the actual geometry of the edge of the opening has a significant effect on the characteristics of the device by varying the area and dielectric thickness of the MIS diode.

FIG. 2 illustrates the major process steps of fabricating a Schottky barrier diode which is not subject to the above-mentioned disadvantages of the diode illustrated in FIG. 1. FIG. 2(a) illustrates the starting material for fabricating the diode, namely a silicon wafer 20. An epitaxial layer 22 of silicon having a resistivity of e.g., 0.25 ohm cm is grown on the top surface of the silicon wafer to a thickness of about 200 nm (FIG. 2(b)). A barrier layer 24 of $MoSi_2$ and a barrier metal layer 26 of TiW are deposited on top of the epitaxial layer 22, to thicknesses of 50 nm and 100 nm respectively (FIG. 2(c)) and a layer 28 of photoresist is deposited on top of the TiW layer 26, and the photoresist is used to pattern the TiW (FIG. 2(d)). The photoresist is then removed, and the patterned TiW is used as a mask for selective etching of the $MoSi_2$ and the silicon to form a mesa 30 (FIG. 2(e)). The silicon is etched to a depth greater than 200 nm, so that the boundary 32 between the epitaxial layer 22 and the wafer material 20 is above the base of the mesa.

After formation of the mesa, silicon dioxide 34 is deposited over the exposed surface of the wafer and over the mesa, for example by plasma deposition, to a depth of 1,000 nm (FIG. 2(f)), and a via 36 is cut in the oxide using conventional selective etching techniques so as expose the TiW on top of the mesa at the central region of the mesa while leaving an annular region of TiW surrounding the central region covered (FIG. 2(g)). An intermediate barrier layer 38 of TiW is deposited over the patterned silicon dioxide 34 and the exposed TiW of the layer 26, to a thickness of 250 nm, and a layer 40 of Pd is deposited over the layer 38 of TiW to a depth of 40 nm (FIG. 2(h)). Photoresist 42 is then deposited over the layer of Pd, and is removed from over the mesa 30 and the immediately surrounding area (FIG. 2(i)). Gold 44 is then plated onto the exposed Pd of the layer 40 to a thickness of 1,000 nm. The remaining photoresist is removed and the layers of Pd and TiW which are not covered by the gold plating are removed by etching (FIG. 2(j)).

In the device illustrated in FIG. 2(j), the device perimeter, at which device degradation occurs, is at the periphery of the mesa, and thus removed from the edge of the via 36, at which physical stress concentrations in the oxide 34 are high. The intermediate barrier layer 38 serves to disperse physical stress concentrations that would otherwise exist at the edge of the via. The spacing of the perimeter of the passivation via from the perimeter of the barrier layer also avoids sharp-edge effects and the formation of an MIS diode in parallel with the normal Schottky diode. Finally, by using a mesa structure there are no sharply curved boundaries between the substrate and the epitaxial layer, which would cause premature breakdown of the diode under reverse-bias stress.

It will be appreciated by those skilled in the art that the invention is not restricted to the particular device and method which have been described, since variations may be made therein without departing from the scope of the invention as defined in the appended claims and equivalents thereof. For example, it may be possible in some circumstances to avoid the need for the layer 38.

CLAIMS

1. A method of manufacturing a semiconductor device, comprising the steps of:

(a) providing a layer of barrier metal on a restricted surface region of a body of semiconductor material, while leaving other regions of the surface, surrounding said restricted surface region, exposed;

(b) providing a layer of insulating material over said other regions of the surface of the body of semiconductor material and over a peripheral region of the layer of barrier metal while leaving a central region of the layer of barrier metal exposed through an aperture in the layer of insulating material; and

(c) establishing ohmic connection to the central regions of the layer of barrier metal by way of said aperture in the layer of insulating material.

2. A method according to claim 1, comprising depositing a layer of intermediate barrier metal on top of the layer of barrier metal prior to depositing the layer of insulating material.

3. A method according to claim 2, wherein the ohmic connection is established by depositing a second layer of intermediate barrier metal on top of the layer of intermediate barrier metal and depositing a layer of electrode metal on top of the second layer of intermediate barrier metal.

4. A method according to claim 1, wherein step (a) is accomplished by depositing a layer of barrier metal on a substantially planar surface of said body of semiconductor material, removing the barrier metal from regions of said surface other than said restricted surface region, and removing semiconductor material from said regions so as to provide a mesa having a layer of barrier metal on its top surface.

0146212

-8-

5. A method according to claim 4, wherein the operation of removing semiconductor material from said regions is accomplished by selective etching using the barrier metal as a mask.

6. A semiconductor device comprising a body of semiconductor material having a major surface, a layer of barrier metal on a restricted surface region of the major surface on the body of semiconductor material, a layer of insulating material covering regions of the major surface of the body of semiconductor material other than said restricted region and also covering the perimeter of the layer of barrier metal, and means for establishing ohmic connection to a central region of the layer of barrier metal.

7. A method of manufacturing a semiconductor device, comprising the steps of:

(a) providing a body of semiconductor material having a region of one conductivity type, said region being bounded by a substantially planar surface of the body and extending to a substantially uniform first predetermined depth beneath said surface;

(b) providing a layer of barrier metal on said surface of the body;

(c) removing the barrier metal from selected regions of said surface and removing semiconductor material from said selected regions to a second predetermined depth, greater than said first predetermined depth so as to provide a mesa having a layer of barrier metal on its top surface; and

(d) establishing ohmic contact to the layer of barrier metal on the top surface of the mesa.

8. A method according to claim 7, wherein the operation of removing semiconductor material from said selected regions is accomplished by selective etching using the barrier metal as a mask.

9. A semiconductor device comprising a body of semiconductor material having a mesa extending from one surface thereof, the mesa having a top surface and including a region of semiconductor material of one type bounded by said top surface and a generally planar surface at a depth below said top surface which is less than the height of the mesa, and the device also comprising a layer of barrier metal on said top surface of the mesa, and means for establishing ohmic contact to said layer of barrier metal.

FIG. 2

0146212

(h)

(i)

FIG. 2 (CONT.)

FIG. I

# European Patent Office

## EUROPEAN SEARCH REPORT

. Application number

EP 84 30 6239

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-3 523 223 (A.H. LUXEM et al.) * Claim; column 3, line 6 - column 4, line 56; column 5, lines 5-12; figures 1-7 * | 1,2,4, 6,7,9 | H 01 L 21/285 H 01 L 29/91 H 01 L 29/40 |
| | --- | | |
| A | DE-A-3 005 301 (LICENTIA) * Claims 3-5,7,8; page 7, lines 2-26; figure 1 * | 6,9 | |
| | --- | | |
| A | DE-A-3 005 302 (LICENTIA) * Claims 2-7; page 7, line 8 - page 8, line 25; figure 1 * | 6,9 | |
| | --- | | |
| A | IEEE TRANSACTIONS ON ELECTRON DEVICES, vol. ED-21, no. 2, February 1974, New York, USA; F. GUTKNECHT et al. "Thermally oxidized mesa Schottky barrier diodes" * Pages 172-173 * | | TECHNICAL FIELDS SEARCHED (Int. Cl.4) |
| | ----- | | H 01 L 21/285 H 01 L 29/40 H 01 L 29/91 |

The present search report has been drawn up for all claims

| Place of search BERLIN | Date of completion of the search 30-11-1984 | Examiner ROTHER A H J |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82